(19) **Europäisches Patentamt European Patent Office Office européen des brevets**

(11) **EP 3 375 904 B1**

(12) **EUROPEAN PATENT SPECIFICATION**

(45) Date of publication and mention of the grant of the patent:
**04.05.2022 Bulletin 2022/18**

(21) Application number: **17160921.7**

(22) Date of filing: **14.03.2017**

(51) International Patent Classification (IPC):
**C04B 35/46** (2006.01) **C04B 35/653** (2006.01)
**C23C 4/11** (2016.01) **C23C 4/134** (2016.01)
**C23C 4/16** (2016.01) **C23C 14/34** (2006.01)

(52) Cooperative Patent Classification (CPC):
**C23C 14/3414; C04B 35/46; C04B 35/653;**
**C23C 4/11; C23C 4/134; C23C 4/16;**
C04B 2235/3237; C04B 2235/5436; C04B 2235/79;
C04B 2235/80; C04B 2235/96

(54) **CYLINDRICAL TITANIUM OXIDE SPUTTERING TARGET AND PROCESS FOR MANUFACTURING THE SAME**

ZYLINDRISCHES TITANOXID-SPUTTERTARGET UND VERFAHREN ZUR HERSTELLUNG DAVON

CIBLE DE PULVÉRISATION D'OXYDE DE TITANE CYLINDRIQUE ET SON PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**19.09.2018 Bulletin 2018/38**

(73) Proprietor: **Materion Advanced Materials Germany GmbH**
**63755 Alzenau (DE)**

(72) Inventors:
• **SCHULTHEIS, Markus**
  **36103 Flieden (DE)**
• **SIMONS, Christoph**
  **63599 Biebergemünd (DE)**
• **SCHLOTT, Martin**
  **63075 Offenbach (DE)**

(74) Representative: **Kador & Partner PartG mbB**
**Corneliusstraße 15**
**80469 München (DE)**

(56) References cited:
**EP-A1- 1 693 482       EP-B1- 0 871 794**
**CN-A- 101 705 467     US-A1- 2004 115 362**

• **STORZ O ET AL: "Tribological properties of thermal-sprayed Magneli-type coatings with different stoichiometries (Ti"nO"2"n"-"1)", SURFACE AND COATINGS TECHNOLOGY, ELSEVIER BV, AMSTERDAM, NL, vol. 140, no. 2, 30 May 2001 (2001-05-30), pages 76-81, XP027301188, ISSN: 0257-8972 [retrieved on 2001-05-30]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical field

The present invention relates to a cylindrical sputtering target comprising a substrate and a target material that forms a layer on the substrate, said layer has a thickness d, wherein the target material comprises sub-stoichiometric TiOx as the main component.

The invention further relates to a process for producing a sputtering target, said process comprises

(a) providing a substrate made of a metal or alloy,
(b) providing a ceramic powder comprising a metal oxide powder of the chemical formula TiOy as the main component, whereby TiOy is deficient in oxygen as compared with the stoichiometric composition $TiO_2$, and
(c) forming a ceramic layer on the substrate by plasma spraying, wherein said ceramic powder is made in a semi-molten state in a high temperature plasma gas in a reducing atmosphere, and it is transported and deposited onto the substrate by the plasma gas so as to obtain a target comprising a layer with a thickness d of a target material that comprises TiOx as the main component, whereby TiOx is deficient in oxygen as compared with the stoichiometric composition $TiO_2$.

Sputter target are used for forming transparent titanium dioxide films having a high refractive index (n=2.4) by direct current (DC) sputtering for heat reflecting glasses, antireflection films, interference filters, polarizing films and photocatalytic films, as well as for multi-layer stacks having an antistatic, heat reflecting or electromagnetic wave shielding function, such glasses are used for example for buildings or automobiles, CRT or a flat displays.

There are different types of sputtering targets, such as planar magnetron and cylindrical rotatable magnetron targets. Planar magnetrons may have an array of magnets arranged in the form of a closed loop and mounted in a fixed position behind the target. For sputtering over a large area, e.g. for a glass sheet for buildings, usually a magnetron type rotary cathode made of a hollow cylindrical target is required. A magnetic field is generated from the inside of the inner bore of the cylindrical target and sputtering is carried out while rotating the target and cooling the target from inside. By the use of such a cylindrical target, a large power per unit area can be applied as compared with a planer type target, whereby film formation at a high speed is possible.

A cylindrical rotatable magnetron sputtering target typically includes a substrate tube within which is the magnet array.

Prior art

Among various sputtering methods, DC sputtering utilizing direct current discharge is suitable for forming a uniform film over a substrate having a large area. When a high refractive index titanium oxide film is to be formed by DC sputtering, a socalled reactive sputtering is employed wherein a metallic target having electroconductivity is subjected to sputtering in a reactive or partially reactive gas atmosphere containing oxygen.

However, there has been a problem that the film-forming speed of a thin film obtainable by this method is very slow, whereby the productivity is poor, and the cost tends to be high. To solve that problem EP 871 794 B1 proposes using a target which comprises a metallic substrate covered by a layer of an electrical conductive target material comprising TiOx as the main component, wherein x is within a range of 1<x<2, that means it is deficient in oxygen as compared with the stoichiometric composition $TiO_2$. Sub-stoichiometric titanium dioxide, TiOx, where x is in the range of from 1.55 to 1.95 is known in the art. Depending upon the stoichiometry the electrical conductivity will vary. Due to its conductivity the sub-stoichiometric TiOx target material is suitable for DC sputtering in a mixed gas atmosphere of argon and oxygen.

The target material may be formed by spraying or sintering and bonding it onto the outer surface of the substrate tube. EP 871 794 B1 proposes a process which comprises plasma spraying titanium dioxide ($TiO_2$) powder optionally together with niobium oxide, onto a rotatable substrate tube in an atmosphere which is oxygen deficient and which does not contain oxygen-containing compounds. The molten sub-stoichiometric TiOx is solidified onto the substrate by cooling under conditions which prevent the sub-stoichiometric titanium dioxide from combining with oxygen.

In another process for providing a sub-stoichiometric TiOx sputtering target capable in high-output direct-current (DC) sputtering without generating target cracks, JP 2016-017196 A proposes a sputtering target material having a TiOx composition, where 1.8<x<1.9. The sputtering target material is formed of a sintered body obtained by sintering a mixed powder obtained by mixing 95-99 wt.-% of the total amount of $TiO_2$ with 1 to 5 wt.-% of a metallic titanium powder.

Object of the invention

Use of rotating cylindrical magnetrons instead of planar magnetrons has several advantages. A cylindrical target may contain more target material and it has a superior utilization yield, which results in much longer production runs and reduced downtime of the machine. Because the heat load is divided equally over the circumference of the target a higher power density can be applied thereby resulting in an increased deposition speed.

Plasma spraying is a coating process using plasma as a heat source to semi-melt feedstock materials, typically in powder form. The high process temperatures allow the ceramic titanium oxide to be melted; the resulting heated droplets are accelerated by process gases and propelled towards the substrate, e.g. a backing tube of a cylindrical target. Upon impact, the droplets are deformed to splats and solidify rapidly to form a coating or layer. The high cooling rates result in a conductive TiOx material.

Plasma spraying is characterized by a high deposition rate. Because of the high cooling rates of the process the backing tube is hardly affected by any thermal interaction with the molten droplets so no diffusion layer between the substrate and the coating is formed. This means that the target material preserves its desired composition over the whole layer thickness and maximizes the utilization of target material for sputter deposition. Because of these advantages, plasma spraying of the target material onto the outer surface of the cylindrical substrate is a preferred method to produce sputter targets.

However, the maximum layer thicknesses applied by those coating processes is typically limited to 10 millimeters. That limitation narrows the advantage concerning utilization yield, longer production runs and reduced downtime of the machine. A possible reason for that limitation is that troubles are likely to occur such as cracking of the target layer and peeling off. In addition to that brittle fractures in the target layer was observed at high power levels.

Accordingly, it is an object of the present invention to provide an improved process for the production of large-sized cylindrical sputtering targets comprising sub-stoichiometric $TiO_x$, which can be used as targets at high power levels.

Furthermore, it is an object of the invention to provide large-sized cylindrical sputtering targets comprising sub-stoichiometric $TiO_x$ with a target layer thickness of at least 12 mm.

Summary of the invention

The sputtering target of the invention

Starting from a generic type sputtering target as specified above, the object is achieved in accordance with the invention in that the target layer thickness d is at least 12 mm and x is within a range of 1.45<x<1.65.

The above object concerning a large-sized cylindrical sputtering targets comprising sub-stoichiometric $TiO_x$, which can be used as targets at high power levels can be met if at the same time, the following features are fulfilled:

(1) the target layer is produced by plasma spraying,

(2) the grade of sub-stoichiometry of the TiOx is higher than usual so that x is in the range between 1.45 and 1.65, and more preferred x is in the range between 1.50 and 1.65 and most preferred x < 1.55,

(3) the layer thickness over at least a part of the length of the substrate is at least 12 mm, more preferred at least 14 mm, and most preferred it is at least 16 mm.

The substrate onto which the target layer is deposited may be a substrate tube made of a metal or a metal alloy like stainless steel, and often it has one or more top coatings or an undercoat layer for improving the bonding of the target material; the undercoat layer may have a thermal expansion coefficient intermediate between the thermal expansion coefficient of the TiOx layer and the thermal expansion coefficient of the substrate, and/or a layer having a thermal expansion coefficient close to the thermal expansion coefficient of the TiOx layer and/or a layer having a higher ductility compared to the material of the substrate and/or the target material.

The main component of the target material being TiOx means that additives like niobium oxide, zirconia or yttrium oxide may be present in small amounts but in total less than 50 atom-% of the target material. The share of TiOx is more than 50 atom-%, preferably it is more than 75 atom-%, more preferred it is more than atom-90 % and most preferred the target material completely consists of TiOx.

Sub-stoichiometric titanium dioxide TiOx, where x is in the range of from 1.45 to less than 1.65 has a high electrical conductivity so that the target material is suitable for sputtering sub-stoichiometric and stoichiometric $TiO_2$ layers in a reactive or partially reactive DC sputtering process, for example using mixed gas atmosphere of argon and oxygen. It was found that sputtering targets with such thick target layers show a reduced susceptibility to cracking even when they are processed at high power levels up to 15 kW/m.

Furthermore, when compared to conventional target layers made of sub-stoichiometric titanium dioxide TiOx, target layers according to the invention made of sub-stoichiometric titanium dioxide TiOx, where x is in the range of from 1.45 to less than 1 .65 show stronger bonding and better heat transfer to the substrate both

in the production of the target layer and during the sputtering process, so that no peeling off occurs.

It has been found advantageous when the target material has a Vickers hardness HV, wherein HV < 500 HV10, preferably HV < 475 HV10.

Here, the unit "HV10" represents the Vickers hardness (HV), evaluated using a Vickers hardness testing machine applying a 10 kilopond load. The method for measuring hardness according to Vickers is specified in DIN EN ISO 6507-1. Testing methods for the evaluation of the micro hardness of metallic coatings are specified in DIN ISO 4516. To convert a Vickers hardness number into MPa (SI units) one multiplies by 9.807.

A hardness degree of HV < 500 HV10 is low when compared to conventional target layers made of sub-stoichiometric titanium dioxide. A low hardness reduces the target layer's susceptibility to brittle cracks.

In the ideal case, the sputtering target according to invention is free from any visible surface cracks; if any surface cracks exist, they show hair-crack characteristics with a web-like structure with a maximum web-cell size less than 1 cm.

The target layer made of sub-stoichiometric titanium oxide TiOx, where x is in the range of from 1.45 to 1.7, preferably where x in the range between 1.50 and 1.65, most preferred x < 1.55 shows crystalline phases and a phase concentration distribution which advantageous affects brittleness and bonding strength of the target material.

One embodiment of the target material comprises a $Ti_4O_7$ phase in a concentration of at least 30 vol.-%, and a $Ti_3O_5$ phase in a concentration of at least 40 vol.-%, wherein preferably the sum of the concentration of the $Ti_4O_7$ and $Ti_3O_5$ phases is at least 75 vol.-%, most preferred at least 99 vol.-%.

A further embodiment of the target material comprises a $Ti_3O_5$ phase in a first concentration (in vol.-%) and a $Ti_4O_7$ phase in a second concentration (in vol.-%), wherein the ratio of first concentration and second concentration $[Ti_3O_5]/[Ti_4O_7]$ is at least 1.2, preferably the ratio $[Ti_3O_5]/[Ti_4O_7]$ it is at least 1.4.

In a further preferred embodiment of the invention, the target material comprises an Anatase phase of $TiO_2$ in a total concentration of less than 1 vol.-%.

It has proved beneficial if the degree of sub-stoichiometry, represented by the x-value in TiOx, is constant over the volume of the target layer. In view of that a preferred sputtering target material comprises a homogeneous degree of sub-stoichiometry, in the sense that the degree of sub-stoichiometry of ten samples of 10 g each has a standard deviation in the of sub-stoichiometry degree of less than $\pm$ 5%.

The process of the invention

Starting from the process of the generic type specified at the outset, the above-mentioned object is achieved in accordance with the invention, in that said metal oxide powder TiOy is within a range of 1.3<y<1.7, and wherein x in said target material TiOx is within a range of 1.45<x<1.65, and the layer thickness d is at least 12 mm.

According to the invention, a ceramic target layer is deposited on a substrate by plasma spraying of a ceramic starting powder. The sub-stoichiometric composition of the TiOx material of the target layer is characterized by 1.45<x<1.65. Generally, the starting powder may have the same sub-stoichiometric composition as the material of the target layer. However, it was observed that a certain oxidation of titanium may occur during plasma spraying, especially at the high end of the oxygen deficiency (around y=1.45). Therefore, preferably the starting TiOy powder material may have a higher grade of oxygen deficiency than the resulting target material, especially at the high end of the oxygen deficiency. Therefore, the starting ceramic TiOy powder is characterized by a sub-stoichiometric composition, whereby: 1.3<y<1.7.

Surprisingly, it was found that the usual 10 mm limitation of target layer thickness d can be overcome if the grade of sub-stoichiometry of the TiOx of the target material is increased so that x is below 1.65. The above object concerning the process for manufacturing a large-sized cylindrical sputtering target comprising sub-stoichiometric $TiO_x$, which can be used as targets at high power levels, can be met if at the same time, the following features are fulfilled:

(1) the target layer is produced by plasma spraying a ceramic metal oxide powder of the chemical formula TiOy as the main component, whereby TiOy is deficient in oxygen as compared with the stoichiometric composition $TiO_2$, whereby: 1.3<y<1.7. Preferably, for plasma spraying an oxygen deficient titania powder is provided having a particle size in the range of from 25-125 $\mu$m, preferably in the range of from 40-90 $\mu$m.

(2) The grade of sub-stoichiometry of the TiOx is higher than usual so that x is in the range between 1.45 and 1.65, and more preferred x is in the range between 1.50 and 1.65 and most preferred x < 1.55.

(3) The layer thickness of the target layer over at least a part of the length of the substrate is at least 12 mm, more preferred at least 14 mm, and most preferred it is at least 16 mm.

The substrate onto which the target layer is deposited may be a substrate tube made of a metal or a metal alloy like stainless steel, and often it has one or more top coatings or an undercoat layer for improving the bonding of the target material; the undercoat layer may have a thermal expansion coefficient intermediate between the thermal expansion coefficient of the TiOx layer and the thermal expansion coefficient of the substrate, and/or a layer may have a thermal expansion coefficient close to the thermal expansion coefficient of the TiOx layer, and/or a layer having a ductility which is higher than that of the material of the substrate tube and/or higher than that of the target material.

Sub-stoichiometric titanium dioxide TiOx, where x is in the range of from 1.45 to less than 1.65 has a high electrical conductivity so that the target material is suitable for sputtering sub-stoichiometric and stoichiometric $TiO_2$ layers in a reactive or partially reactive DC sputtering process, for example using mixed gas atmosphere of argon and oxygen. It was found that sputtering targets with such thick target layers show a reduced susceptibility to cracking even when they are processed at high power levels up to 15 kW/m.

Furthermore, when compared to conventional target layers made of sub-stoichiometric titanium dioxide TiOx, target layers according to the invention made of sub-stoichiometric titanium dioxide TiOx, where x is in the range of from 1.45 to less than 1 .65 show stronger bonding and better heat transfer to the substrate both in the production of the target layer and during the sputtering process, so that no peeling off occurs.

Measuring methods

Vickers hardness test

For preparation test samples are embedded in a resin on basis of methylmetacrylate. After hardening a metallographic preparation including grinding down to a diamond grain size of 1200 mesh and a final polishing is made so that the sample to be tested is free of streaks. The Vickers hardness test method consists of indenting the test sample with a diamond indenter, in the form of a pyramid with a square base and an angle of 136 degrees. The intender is pressed vertically into the surface of the sample using a test load F. The full load is normally applied for 10 to 15 seconds. The two diagonals of the indentation left in the surface of the material after removal of the load are measured using a microscope and their average calculated. From that value the Vickers hardness can be calculated or it can be metered from a Vickers HV hardness table.

Phase analysis and determination of the phase content

Test samples are powdered using a mortar. The powders are irradiated by a two circle goniometer Stadi P of the company Stoe & Cie in transmission mode with X-rays CuK alpha 1 (= 1.54056 Angstrom). The linear position-sensitive detector (LPSD) is used with a range of 6.60 ° between 2 theta (3,000° to 79,990°), step size 0.010. The measuring duration is 240 seconds in increments of 0.55° (20 sec/step), so the entire measurement lasts 6.47 hours. The used generator operates at a voltage of 40 kV and at a current of 30 mA. Adjustment and calibration of the instrument is based on the NIST standard Si (640 d). The volume fractions of the respective phases have been determined as follows: The diffraction diagrams are evaluated by using a software "Rietveld SiroQuant $^{®}$, version V4.0" purchased from Sietronics Pty Ltd. The respective phase contents in the test samples are calculated in shares per volume.

Determination of the reduction degree (x-value in $TiO_x$)

The x-value in $TiO_x$ is determined by taking five samples of about 10 g from the target and the starting powder respectively. The sample material is pulverized in a mortar to a particle size of less than 10 $\mu$m. The thus obtained powder is annealed in pure oxygen at 1100 ° C for 1 hour. For powder samples the pulverization step may be omitted if the particle size of the starting powder is already less than 10 $\mu$m. The weight increase caused by that treatment is measured. The x-value representing the oxygen stoichiometry in the formula $TiO_x$ is then determined from the average weight increase $\Delta G$ ($\Delta G = m(TiO_2) - m(TiO_x)$) from the at least 5 measurements in grams as follows:

$$x = 2 - [\Delta G * M(TiO_2)] / [m(TiO_2) * M(O)]$$

where $M(TiO_2)$ is the molar mass of stoichiometric $TiO_2$ (=79,87g/mol)
$M(O)$ is the molar mass of elemental oxygen (=16 g/mol)
$m(TiO_x)$ is the sample weight in grams measured prior to annealing.
$m(TiO2)$ is the sample weight in grams measured after annealing.

Measuring the adhesive strength of the target layer on a backing tube

An impact hammer test is used to determine the adhesive strength of the target layer. Laminated specimens with the compositions of $TiO_{1.8}$ and $TiO_{1.6}$ are produced by plasma spraying on stainless steel substrate including an undercoating of nickel metal in analogy to the production of the target tubes of examples 1 und 2. The sprayed bands have a thickness of 6 mm and a width of 250 mm.

The hammer impact test is carried out by striking an hammer onto the surface of the specimens, the hammer coming from the same height and hits the surface at the same speed. After the impact the surface is tested for any cracks by using the ethanol visualization test.

Ethanol visualization test

For proving a crack free surface an ethanol visualization test is used. Liquid ethanol is injected onto the test sample so that it is completely covered with ethanol. Due to a faster evaporation of ethanol on the plane surface of the sample compared to the ethanol evaporation in the cracks, a visible color difference occurs (dark/bright), so that any existing cracks are visible as dark vein-like lines or crossshaped patterns. A target material is defined as being free of cracks if it contains no crack with a total length of more than 1 cm.

Preferred embodiments of the invention

The invention will now be explained in more detail with reference to a patent drawing and an embodiment. In detail,

**Figure** 1    shows an X-ray diffraction diagram of a target layer material according to the invention in combination with the typical deflection signals of $Ti_3O_5$ and $Ti_5O_7$ crystalline phases, and

**Figure 2**    shows an X-ray diffraction diagram of a target layer material according to the invention in combination with the typical deflection signals of $TiO_2$ in its rutile crystalline phase.

Preparation of sputtering target

As feedstock material a non-stoichiometric oxygen deficient titania powder was provided having a particle size in the range of from 25-125 $\mu$m. The degree of sub-stoichiometry is represented in the formula $TiO_y$ by y~1.4.

A stainless steel tube was provided with an of outer diameter of 133 mm and an inner diameter of 125 mm. Suitable lengths of the substrate tube are in the range between 500 to 4.000 mm. The tube was coated with a rough Ni layer. The coated stainless steel tube was used as a substrate for depositing a target material by plasma spraying, whereby the rough Ni undercoating acts a bonding layer for the target material.

For plasma spraying the $TiO_y$ feedstock materials, a water-cooled plasma torch device was used. The plasma torch was operated with a mixture of hydrogen and argon with variable mixing ratio. The hydrogen/argon mixing ratio determines the reduction/oxidation state of the plasma; details about the mixing ratio used in the examples are provided further below. The process gas may also contain Helium. The sub-stoichiometric $TiO_y$ powder was injected via a carrier gas directly into the plasma flame. The powder feed rate is set at a value in the region between 50 g/min and 350 g/min.

The sub-stoichiometric titanium dioxide coated on the substrate is solidified under conditions which prevent it from regaining oxygen and reconverting to $TiO_2$. Especially at high feed rates or at high power levels the substrate may be cooled (e.g. gas cooling on outside or water cooling on the inside to 35°C) during the plasma spraying in order to quench the titanium dioxide in its deposited sub-stoichiometric form. A $TiO_x$ target material layer with a thickness of more than 10 mm is prepared, whereby in the formula $TiO_x$ the grade of sub-stoichiometry is represented by $x > 1,54$ and $x \leq 1,81$ (see table 1). The resulting sputtering target comprises the substrate and the target layer of $TiO_x$.

Example 1 (not according to the invention)

A rotatable substrate tube with a tube length of 550 mm was provided comprising a backing tube of stainless steel of outer diameter 133 mm, inner diameter 125 mm, length 550 mm. The outer cylinder surface was coated with a Ni layer.

It was water cooled on the inside to 35°C and thereby coated by plasma spraying with a powder of sub-stoichiometric titanium oxide ($TiO_y$, whereby y=1,69) having a particle size of from 40 to 90 $\mu$m using argon as the primary plasma gas and hydrogen as the secondary plasma gas (70 vol.-% argon, 30 vol.-% hydrogen). The power level was 60kW (400A).

The resulting target layer has a thickness of from 11 mm and it consists of sub-stoichiometric titanium dioxide (TiOx, where x is 1.71, see Table 1). The subsequently performed ethanol visualization test shows that it is crack free. The hammer impact test shows strong adhesion of the target material to the substrate tube and less susceptibility to cracking compared to comparative example 1.

The process for production of the sputter target was repeated several times but target layers of 12 mm and more were produced instead a target layer thickness of 11 mm. The ethanol visualization test showed a crack free layer which could be produced with high reproducibility for a maximum layer thickness of 11 mm.

Example 2

Example 1 was repeated using a starting powder of sub-stoichiometric titanium oxide (TiOy, whereby y=1.40) having a particle size of from 5 to 45 $\mu$m was used as the feedstock material. Argon was used as the primary plasma gas and hydrogen as the secondary plasma gas (70 vol.-% argon, 30 vol.-% hydrogen). The power level was the same as in Example 1.

The resulting target layer has a thickness of from 14 mm and it consists of sub-stoichiometric titanium oxide (TiOx, where x is 1.63). When spraying onto a target base under the conditions of Example 2 the TiOy was converted into a sub-stoichiometric rutile form of titanium dioxide. The subsequently performed ethanol visualization test shows that it is crack free. The hammer impact test shows strong adhesion of the target material to the substrate tube and less susceptibility to cracking compared to comparative example 1.

The process for production of the sputter target was repeated several times but target layers of 15 mm and more were produced instead a target layer thickness of 14 mm. The ethanol visualization test showed a crack free layer could be produced with high reproducibility for a maximum layer thickness of 14 mm.

Example 3

Example 1 was repeated using a powder of sub-stoichiometric titanium oxide (TiOy, whereby y=1.32) having a particle size of from 40 to 90 $\mu$m. Argon was used as the primary plasma gas and hydrogen as the secondary plasma gas (70 vol.-% argon, 30 vol.-% hydrogen). The power level was the same as in Example 1.

The resulting target layer has a thickness of from 18 mm and it consists of sub-stoichiometric titanium oxide (TiOx, where x is 1.54). On spraying onto a target base under the conditions of Example 2 the $TiO_2$ was converted into a sub-stoichiometric rutile form of titanium dioxide.

Example 4

Example 3 was repeated using a rotatable substrate tube with a tube length of 2000 mm. The resulting target layer has a thickness of from 16 mm and it consists of sub-stoichiometric titanium oxide (TiOx, where x is 1.53).

Example 5

Example 3 was repeated using a rotatable substrate tube with a tube length of 3852mm. The resulting target layer has a thickness of from 15 mm and it consists of sub-stoichiometric titanium oxide (TiOx, where x is 1.54).

Comparative Example 1

Example 1 was repeated using a powder of sub-stoichiometric titanium oxide (TiOy, whereby y=1.81) having a particle size of from 40 to 90 $\mu$m. Argon was used as the primary plasma gas and hydrogen as the secondary plasma gas (70 vol.-% argon, 30 vol.-% hydrogen). The power level was the same as in Example 1.

The resulting target layer has a thickness of from 11 mm and it consists of sub-stoichiometric titanium oxide (TiOx, where x is 1.82). When spraying onto a target base under the conditions of Example 2 the TiOy feedstock particles were converted into a sub-stoichiometric TiOx. The mayor phase is $Ti_9O_{17}$ and it includes small amounts of the rutile form and the anatase form of titanium dioxide (see Table 1).

Cracks occur in the target material.

Therefore, the production of the sputter target according to Comparative Example 1 was repeated, but instead of a layer thickness of 11 mm, the target material deposition was stopped at a layer thickness of 10 mm and less. The ethanol visualization test showed a crack free layer which could be produced with high reproducibility only for a maximum layer thickness of 10 mm.

**Table 1**

| Example | Short nomination in the specification | $TiO_2$ Anatase Vol.-% | $TiO_2$ Rutile Vol.-% | $Ti_9O_{17}$ Vol.-% | $Ti_4O_7$ Vol.-% | $Ti_3O_5$ Vol.-% | Hardnes HV10 | Stoechiochiometry Powder (y-value) | Stoechiometry Target (x-value) | Maximal crack free layer thickness (mm) |
|---|---|---|---|---|---|---|---|---|---|---|
| 1 | $TiO_{1,7}$ | 0 | 4,0 | 24 | 32 | 40 | 520 | 1,69 | 1,71 | 11 |
| 2 | $TiO_{1,6}$ | 0 | 2,0 | 0 | 42 | 56 | 480 | 1,40 | 1,63 | 14 |
| 3 | $TiO_{1,5}$ | 0 | 1,0 | 0 | 40 | 59 | 450 | 1,32 | 1,54 | 18 |
| Comp. 1 | $TiO_{1,8}$ | 1,0 | 6,0 | 93 | 0 | 0 | 570 | 1,82 | 1,81 | 10 |

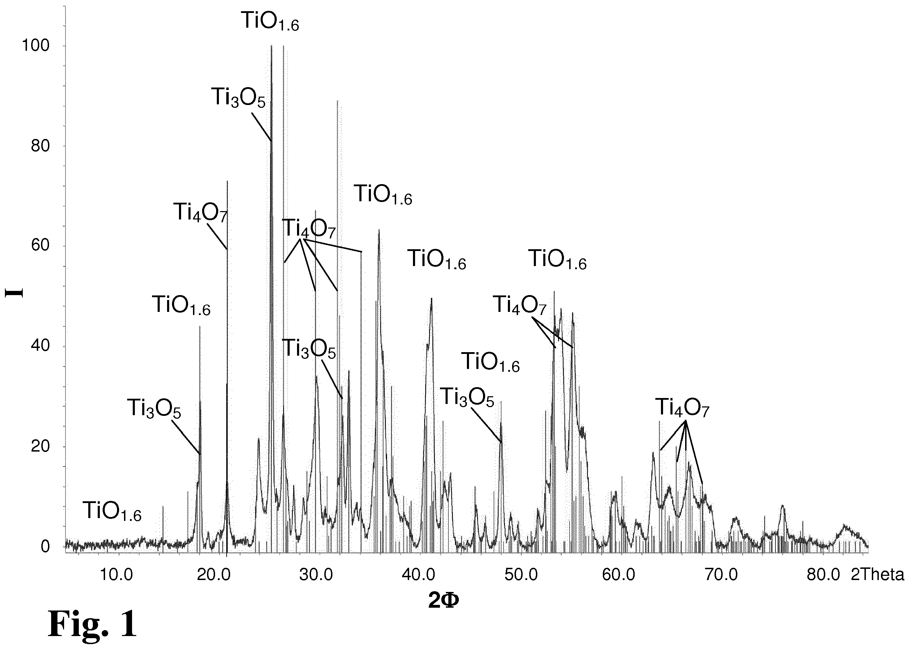

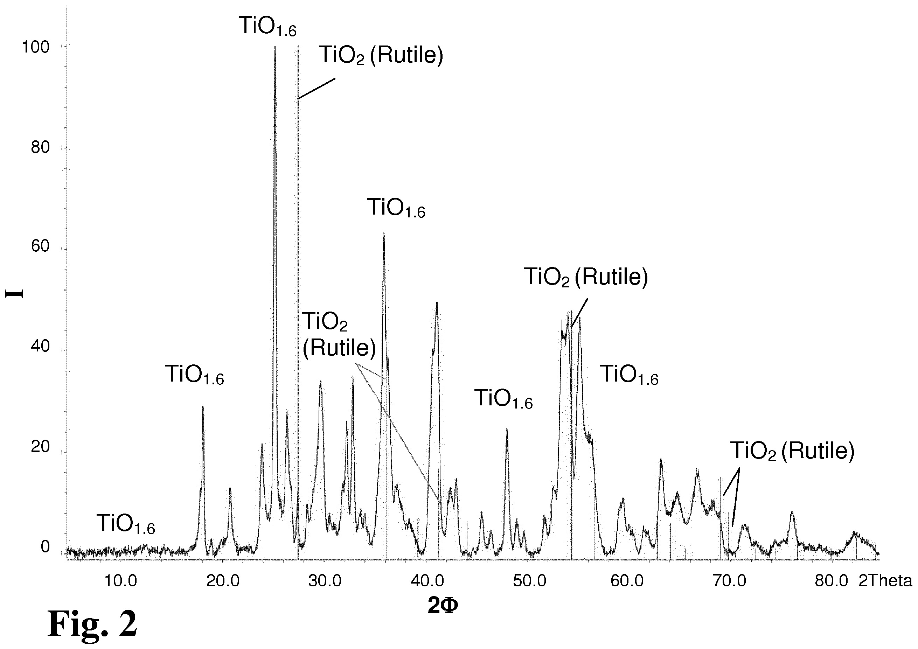

The results of the XRD measurement are shown in Figures 1 and 2 and summarized in Table 1.The major phases of the target material of Examples 1 to 3 are $Ti_3O_5$ and $Ti_4O_7$. The total volume share of these phases is at least 75 vol.-%. In the qualitatively best sample (Example 3) the total share of these phases is even 99 vol.-%. The ratio of the volume shares of the phases $Ti_3O_5/Ti_4O_7$ calculated on the basis of the XRD graph is 0.59/0.40=1.48.

The $TiO_{1.8}$ material (Comp. Example 1) shows cracks and delaminating when the layer thickness of the target material is higher than 10 mm. That maximal crack free target layer thickness made of $TiO_{1.8}$ material is significantly lower than that which can be achieved with target materials $TiO_{1.6}$ and $TiO_{1.5}$. Due to the absence of the phases $Ti_3O_5$ and $Ti_4O_7$ a volume ratio of those phases cannot be calculated.

In the XRD analysis diagram of Fig. 1 the measured defracted intensity I (in relative units; %) of sample 2 ($TiO_{1.6}$) is plotted against diffraction angle 2theta. It shows that $Ti_3O_5$ and $Ti_4O_7$ are the major phases of the microstructure. In addition to that the XRD analysis diagram of **Fig. 2** shows that the microstructure of said Ti01.6 sample has no defraction signal line that can be clearly contributed to $TiO_2$ in its rutile crystalline form.

## Claims

1. A cylindrical sputter target comprising a substrate and a target material that forms a layer on the substrate, said layer has a thickness d, wherein the target material comprises sub-stoichiometric TiOx as the main component, 1 and **characterized in that** d is at least 12 mm and x is within a range of 1.45<x<1.65.

2. The sputtering target according to claim 1, wherein d is at least 14 mm.

3. The sputtering target according to claim 1 or 2, wherein 1.50 < x < 1.65, and most preferred x < 1.55.

4. The sputtering target according to any one of the claims 1 to 3, wherein the target material has a Vickers hardness HV, wherein HV < 500 HV10, preferably HV< 475 HV10.

5. The sputtering target according to any one of claims 1 to 4, wherein the target material comprises a $Ti_4O_7$ phase in a concentration of at least 30 vol.-%, and a $Ti_3O_5$ phase in a concentration of at least 40 vol.-%.

6. The sputtering target according to any one of claims 1 to 5, wherein the target material comprises a Ti407 phase and $Ti_3O_5$ phase in a total concentration of at least 75 vol.-%, preferably at least 99 vol.-%.

7. The sputtering target according to any one of claims 1 to 6, wherein the target material comprises a $Ti_3O_5$ phase in a first concentration (in vol.-%) and a $Ti_4O_7$ phase in a second concentration (in vol.-%), wherein the ratio of first concentration and second concentration $Ti_3O_5/Ti_4O_7$ is at least 1.2, preferably it is at least $Ti_3O_5/Ti_4O_7$ >1.4.

8. The sputtering target according to any one of claims 1 to 7, wherein the target material comprises an Anatase phase of $TiO_2$ in a total concentration of less than 1 vol.-%.

9. The sputtering target according to any one of claims 1 to 8, wherein the target material is free from visible surface cracks, or if surface cracks exist, they have a maximum length of less than 1 cm.

10. Sputtering target according to any one of claims 1 to 9, wherein the target material comprises a homogeneous degree of sub-stoichiometry, in the sense that the degree of sub-stoichiometry of ten samples of 10 g each has a standard deviation in the of sub-stoichiometry degree of less than ± 5%.

11. A process for producing a sputtering target, which comprises

   (a) providing a substrate made of a metal or alloy,
   (b) providing a ceramic powder comprising a metal oxide powder of the chemical formula TiOy as the main component, whereby TiOy is deficient in oxygen as compared with the stoichiometric composition $TiO_2$,
   (c) forming a ceramic layer on the substrate by plasma spraying, wherein said ceramic powder is made in a semi-molten state in a high temperature plasma gas in a reducing atmosphere, and it is transported and deposited onto the substrate by the plasma gas so as to obtain a target comprising a layer with a thickness d of a target material that comprises TiOx as the main component, whereby TiOx is deficient in oxygen as compared with the stoichiometric composition $TiO_2$,

wherein y in said metal oxide powder TiOy is within a range of 1.3<y<1.7, and wherein x in said target material TiOx is within a range of 1.45<x<1.65, and the layer thickness d is at least 12 mm.

12. The process according to claim 11, wherein the thickness d is at least 14 mm, and wherein 1.50 < x < 1.65 and most preferred x < 1.55.

13. The process according to claim 11 or 12, wherein a cylindrical substrate is used as the substrate.

14. The process according to one of the preceding claims 11 to 13, wherein providing the ceramic powder according to method step (b) comprises providing an oxygen deficient titania powder having a particle size in the range of from 25-125 $\mu$m, preferably in the range of from 40-90 $\mu$m.

**Patentansprüche**

1. Zylindrisches Sputtertarget, umfassend ein Substrat und ein Targetmaterial, das eine Schicht auf dem Substrat bildet, wobei die Schicht eine Dicke d aufweist, wobei das Targetmaterial unterstöchiometrisches TiOx als Hauptkomponente umfasst, und **dadurch gekennzeichnet, dass** d mindestens 12 mm beträgt und x in einem Bereich von 1,45 < x < 1,65 liegt.

2. Sputtertarget nach Anspruch 1, wobei d mindestens 14 mm beträgt.

3. Sputtertarget nach Anspruch 1 oder 2, wobei 1,50 < x < 1,65 und besonders bevorzugt x < 1,55.

4. Sputtertarget nach einem der Ansprüche 1 bis 3, wobei das Targetmaterial eine Vickershärte HV aufweist, wobei HV < 500 HV10, vorzugsweise HV< 475 HV10.

5. Sputtertarget nach einem der Ansprüche 1 bis 4, wobei das Targetmaterial eine $Ti_5O_7$-Phase in einer Konzentration von mindestens 30 Vol.-% und eine $Ti_3O_5$-Phase in einer Konzentration von mindestens 40 Vol.-% umfasst.

6. Sputtertarget nach einem der Ansprüche 1 bis 5, wobei das Targetmaterial eine $Ti_4O_7$-Phase und eine $Ti_3O_5$-Phase in einer Gesamtkonzentration von mindestens 75 Vol.-%, vorzugsweise von mindestens 99 Vol.-% umfasst.

7. Sputtertarget nach einem der Ansprüche 1 bis 6, wobei das Targetmaterial eine $Ti_3O_5$-Phase in einer ersten Konzentration (in Vol.-%) und eine $Ti_4O_7$-Phase in einer zweiten Konzentration (in Vol.-%) umfasst, wobei das Verhältnis der ersten Konzentration zu der zweiten Konzentration $Ti_3O_5/Ti_4O_7$ mindestens 1,2 beträgt, vorzugsweise mindestens $Ti_3O_4/Ti_4O_7 > 1,4$.

8. Sputtertarget nach einem der Ansprüche 1 bis 7, wobei das Targetmaterial eine Anatasphase von $TiO_2$ in einer Gesamtkonzentration von weniger als 1 Vol.-% umfasst.

9. Sputtertarget nach einem der Ansprüche 1 bis 8, wobei das Targetmaterial keine sichtbaren Oberflächenrisse aufweist, oder falls Oberflächenrisse vorhanden sind, diese eine maximale Länge von weniger als 1 cm aufweisen.

10. Sputtertarget nach einem der Ansprüche 1 bis 9, wobei das Targetmaterial einen homogenen Substöchiometriegrad aufweist, in dem Sinne, dass der Substöchiometriegrad von zehn Proben zu je 10 g eine Standardabweichung des Substöchiometriegrades von weniger als $\pm$ 5 % aufweist.

11. Verfahren zur Herstellung eines Sputtertargets, umfassend:

(a) Bereitstellen eines Substrats aus einem Metall oder einer Legierung,
(b) Bereitstellen eines keramischen Pulvers, umfassend ein Metalloxidpulver der chemischen Formel TiOy als Hauptkomponente, wobei TiOy im Vergleich zur stöchiometrischen Zusammensetzung $TiO_2$ einen Sauerstoffmangel aufweist,
(c) Bilden einer keramischen Schicht auf dem Substrat durch Plasmaspritzen, wobei das keramische Pulver in einem halbgeschmolzenen Zustand in einem Hochtemperaturplasmagas in einer reduzierenden Atmosphäre hergestellt wird und wobei es durch das Plasmagas auf das Substrat transportiert und abgeschieden wird, um ein Target zu erhalten, das eine Schicht mit einer Dicke d eines Targetmaterials umfasst, das TiOx als Hauptkomponente umfasst, wobei TiOx im Vergleich zu der stöchiometrischen Zusammensetzung $TiO_2$ einen Sauerstoffmangel aufweist,

wobei y in dem Metalloxidpulver TiOy in einem Bereich von 1,3 < y < 1,7 liegt und wobei x in dem Targetmaterial TiOx in einem Bereich von 1,45 < x < 1,65 liegt und die Schichtdicke d mindestens 12 mm beträgt.

**12.** Verfahren nach Anspruch 11, wobei die Dicke d mindestens 14 mm beträgt, und wobei 1,50 < x < 1,65 und besonders bevorzugt x < 1,55.

**13.** Verfahren nach Anspruch 11 oder 12, wobei ein zylindrisches Substrat als Substrat verwendet wird.

**14.** Verfahren nach einem der vorangegangenen Ansprüche 11 bis 13, wobei das Bereitstellen des keramischen Pulvers gemäß Verfahrensschritt (b) das Bereitstellen eines sauerstoffarmen Titandioxidpulvers mit einer Partikelgröße im Bereich von 25-125 $\mu$m, vorzugsweise im Bereich von 40-90 $\mu$m, umfasst.


## Revendications

**1.** Cible de pulvérisation cylindrique comprenant un substrat et un matériau cible qui forme une couche sur le substrat, ladite couche a une épaisseur d, dans laquelle le matériau cible comprend du TiOx sous-stœchiométrique en tant que composant principal, et **caractérisée en ce que** d est d'au moins 12 mm et x est dans une plage de 1,45<x<1,65.

**2.** Cible de pulvérisation selon la revendication 1, dans laquelle d est d'au moins 14 mm.

**3.** Cible de pulvérisation selon la revendication 1 ou 2, dans laquelle 1,50 < x < 1,65, et plus préférentiellement x < 1,55.

**4.** Cible de pulvérisation selon l'une quelconque des revendications 1 à 3, dans laquelle le matériau cible a une dureté Vickers HV, dans laquelle HV < 500 HV10, de préférence HV < 475 HV10.

**5.** Cible de pulvérisation selon l'une quelconque des revendications 1 à 4, dans laquelle le matériau cible comprend une phase de $Ti_4O_7$ à une concentration d'au moins 30 % en volume, et une phase de $Ti_3O_5$ à une concentration d'au moins 40 % en volume.

**6.** Cible de pulvérisation selon l'une quelconque des revendications 1 à 5, dans laquelle le matériau cible comprend une phase de $Ti_4O_7$ et une phase de $Ti_3O_5$ à une concentration totale d'au moins 75 % en volume, de préférence d'au moins 99 % en volume.

**7.** Cible de pulvérisation selon l'une quelconque des revendications 1 à 6, dans laquelle le matériau cible comprend une phase de $Ti_3O_5$ à une première concentration (en % en volume) et une phase de $Ti_4O_7$ à une deuxième concentration (en % en volume), dans laquelle le rapport de la première concentration et de la deuxième concentration $Ti_3O_5/Ti_4O_7$ est d'au moins 1,2, de préférence d'au moins $Ti_3O_5/Ti_4O_7$>1,4.

**8.** Cible de pulvérisation selon l'une quelconque des revendications 1 à 7, dans laquelle le matériau cible comprend une phase anatase de $TiO_2$ à une concentration totale inférieure à 1 % en volume.

**9.** Cible de pulvérisation selon l'une quelconque des revendications 1 à 8, dans laquelle le matériau cible est exempt de fissures de surface visibles, ou si des fissures de surface existent, elles ont une longueur maximale inférieure à 1 cm.

**10.** Cible de pulvérisation selon l'une quelconque des revendications 1 à 9, dans laquelle le matériau cible comprend un degré homogène de sous-stœchiométrie, en ce sens que le degré de sous-stœchiométrie de dix échantillons de 10 g chacun a un écart-type dans le degré de sous-stœchiométrie inférieur à $\pm$ 5 %.

**11.** Procédé pour produire une cible de pulvérisation, qui comprend

(a) la fourniture d'un substrat constitué d'un métal ou d'un alliage,
(b) la fourniture d'une poudre de céramique comprenant une poudre d'oxyde métallique de formule chimique TiOy en tant que composant principal, TiOy étant déficient en oxygène en comparaison de la composition

stœchiométrique $TiO_2$,

(c) la formation d'une couche de céramique sur le substrat par pulvérisation au plasma, dans lequel ladite poudre de céramique est mise en un état semi-fondu dans un gaz en plasma à haute température dans une atmosphère réductrice, et elle est transportée et déposée sur le substrat par le gaz en plasma de manière à obtenir une cible comprenant une couche avec une épaisseur d d'un matériau cible qui comprend du TiOx en tant que composant principal, TiOx étant déficient en oxygène en comparaison de la composition stœchiométrique $TiO_2$,

dans lequel y dans ladite poudre d'oxyde métallique TiOy est dans une plage de 1,3<y< 1,7, et dans lequel x dans ledit matériau cible TiOx est dans une plage de 1,45<x<1,65, et l'épaisseur de couche d est d'au moins 12 mm.

12. Procédé selon la revendication 11, dans lequel l'épaisseur d est d'au moins 14 mm, et dans lequel 1,50 < x < 1,65 et plus préférentiellement x < 1,55.

13. Procédé selon la revendication 11 ou 12, dans lequel un substrat cylindrique est utilisé en tant que substrat.

14. Procédé selon l'une quelconque des revendications 11 à 13 précédentes, dans lequel la fourniture de la poudre de céramique selon l'étape (b) du procédé comprend la fourniture d'une poudre de dioxyde de titane déficiente en oxygène ayant une taille de particule dans la plage de 25 à 125 μm, de préférence dans la plage de 40 à 90 μm.

Fig. 1

Fig. 2

EP 3 375 904 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 871794 B1

- JP 2016017196 A